# EUROPÄISCHE PATENTSCHRIFT

(11) **EP 3 828 581 B1**
(45) Veröffentlichungstag und Bekanntmachung des Hinweises auf die Patenterteilung: **27.12.2023**
(21) Anmeldenummer: 19212159.8
(22) Anmeldetag: 28.11.2019
(51) Int. Cl.: G01R 33/565, G01R 33/48, G01R 33/56

(54) **VERFAHREN ZUR ERZEUGUNG WENIGSTENS EINES BILDDATENSATZES UND EINES REFERENZBILDDATENSATZES, COMPUTERPROGRAMMPRODUKT SOWIE MAGNETRESONANZANLAGE**
METHOD FOR PRODUCING AT LEAST ONE IMAGE DATA SET AND A REFERENCE IMAGE DATA SET, COMPUTER PROGRAM PRODUCT AND MAGNETIC RESONANCE SYSTEM
PROCÉDÉ DE GÉNÉRATION D'AU MOINS UN ENSEMBLE DE DONNÉES D'IMAGE ET D'UN ENSEMBLE DE DONNÉES D'IMAGE DE RÉFÉRENCE, PRODUIT PROGRAMME INFORMATIQUE AINSI QU'INSTALLATION DE RÉSONANCE MAGNÉTIQUE

(43) Veröffentlichungstag der Anmeldung: 02.06.2021
(73) Patentinhaber: Siemens Healthcare GmbH, 91052 Erlangen (DE)
(72) Erfinder: Körzdörfer, Gregor, 91058 Erlangen (DE); Nittka, Mathias, 91083 Baiersdorf (DE)
(74) Vertreter: Siemens Healthineers Patent Attorneys

(56) Entgegenhaltungen:
- US-A1- 2008 169 808
- US-A1- 2014 314 293
- US-B1- 7 888 935

## Beschreibung

Die Erfindung betrifft ein Verfahren zur Erzeugung wenigstens eines Bilddatensatzes und eines Referenzbilddatensatzes eines Untersuchungsobjektes aus wenigstens zwei Rohdatensätzen. Die Erfindung betrifft ferner ein Computerprogrammprodukt sowie eine Magnetresonanzanlage, mit der das vorgenannte Verfahren ausführbar ist.

Bei der Magnetresonanzbildgebung werden Messsequenzen zur Aufnahme von Rohdatensätzen verwendet, aus denen Bilddatensätze prozessiert werden. Mit einer Messsequenz wird der sogenannte k-Raum (z.B. definiert als der Ortsfrequenz-Raum der Spindichteverteilung) abgetastet, wobei an einer Vielzahl von Auslesepunkten Messsignale ortskodiert aufgenommen werden.

Je nach Abtastschema spricht man z.B. von einer kartesischen, spiralförmigen oder radialen Abtastung des k-Raums. Die Bahn, mit der der k-Raum dabei abgetastet wird, wird dabei als k-Raum-Trajektorie bezeichnet.

Bei einer kartesischen Abtastung liegt während des Akquisitionsfensters üblicherweise ein konstanter Lesegradient an, wodurch eine ganze k-Raum-Zeile aufgenommen werden kann. Je nach Messsequenz wird dabei Zeile für Zeile jeweils nach einer Hochfrequenzanregung mit dazwischenliegenden Wartezeiten abgetastet. Bei einer Echo Planar Imaging (EPI)-Messsequenz werden dagegen nach der Anregung eine Vielzahl an k-Raum-Zeilen direkt hintereinander ausgelesen.

Auch bei einer radialen Abtastung kann zwischen der Aufnahme der einzelnen Speichen mit ebenfalls konstantem Lesegradienten, der jedoch von Speiche zu Speiche die Raum-Richtung ändern kann, eine Wartezeit liegen oder eine Multiechoaufnahme vorgenommen werden.

Bei den Spiraltrajektorien erfolgt die Abtastung zumindest eines Teils des k-Raums unter einem zeitlich variierenden Lesegradienten.

Das Abtastschema ist dabei grundsätzlich unabhängig von der eigentlichen Messsequenz. Eine Messsequenz ist eine vorgegebene Abfolge von Hochfrequenz(HF-)impulsen, Magnetfeldgradienten, Akquisitionsfenstern und Wartezeiten. Beispiele für derartige Messsequenzen sind eine Gradientenecho (GE)-Messsequenz, eine Spinecho (SE)-Messsequenz, Fast Low Angle SHot (FLASH), eine Fast Imaging with Steady Precession (FISP)-Messsequenz, eine True Fast Imaging with Steady Precession (TrueFISP)-Messsequenz, eine Turbo Spin Echo (TSE)-Messsequenz, eine Echo Planar Imaging (EPI)-Messsequenz, und viele mehr.

Insbesondere bei einer FLASH-, FISP- oder TrueFISP-Messsequenz kann jedes der genannten Abtastschemata verwendet werden.

Zur Ortskodierung werden Magnetfeldgradienten verwendet. Üblicherweise weist eine zur Bildgebung ausgebildete Magnetresonanzanlage drei Gradientenspulen zur Erzeugung dreier Gradientenfelder auf. Diese stehen senkrecht aufeinander, um eine Ortskodierung in allen Raumrichtungen zu ermöglichen. Durch das gezielte Anlegen von Gradienten in einer ersten und zweiten Bildrichtung, bspw. einer Leserichtung und einer Phasenkodierrichtung, werden die Auslesepunkte, also die Position der Messsignale im k-Raum, festgelegt.

Diese Gradientenfelder werden einem Grundmagnetfeld B0 überlagert. Das Grundmagnetfeld B0 hat bei klinischen Anwendungen oft eine Stärke von 1,5T. Es sind aber auch Magnetresonanzanlagen mit 0,5T oder bis zu 8T bekannt.

Das Grundmagnetfeld B0 sollte in dem Bereich, aus dem Messsignale aufgenommen werden, konstant sein. Dieser Bereich liegt ungefähr in der Mitte einer Magnetresonanzanlage und wird auch homogener Bereich des Grundmagnetfeldes B0 genannt.

Durch das Einbringen einer Probe wird die Homogenität des Grundmagnetfeldes B₀ immer gestört. Daher ist es bekannt, patientenspezifisch Korrekturen vorzunehmen. Dieses Korrigieren wird auch "Shimmen" genannt, weil sogenannte Shimspulen mit Strom beschickt werden können, um das Grundmagnetfeld B0 zu homogenisieren.

Trotz dieser Korrekturen können sogenannte lokale Offresonanzen verbleiben. Eine lokale Offresonanz ist eine vom erwarteten Grundmagnetfeld B0 unterschiedliche Magnetfeldstärke, also eine Abweichung vom erwarteten Grundmagnetfeld B0.

Derartige Abweichungen können insbesondere bei spiralförmigen k-Raum-Trajektorien oder Messsequenzen mit Multigradientenecho-Auslese wie bei einer EPI-Messsequenz zu starken Artefakten führen, da sie die die Phase des Messsignals mit zunehmender Auslesedauer verändern. Dies führt allgemein zur Verschiebung von Bilddaten entlang der Ausleserichtung nach Transformation aus dem Frequenzraum in den Bildraum. Bei Spiraltrajektorien, bei denen die Ausleserichtung variiert, führt dies zu sogenanntem Blurring.

Die US2008/0169808A1 beschreibt einen Magnetresonanztomographen ausgebildet zur Detektion und Kompensation von Körperbewegungen. In der US2014/0314293A1 werden ein System und ein Verfahren zur gemeinsamen Schwächungsabschätzung und Bildrekonstruktion für Magnetresonanz beschrieben. Die US7888935B1 offenbart ein System und ein Verfahren zur k-Raumtrajektorienabschätzung bei MR-Spiralbildgebung.

Es gibt eine Vielzahl von off-Resonanz Korrekturmethoden insbesondere für spiralförmige k-Raum-Trajektorien. Entweder sind diese selbstkalibiriert oder es muss eine externe B₀-Karte gemessen werden. Anhand der B₀-Information können die Messsignale derart manipuliert werden, dass das Verschmieren, Blurring genannt, nicht mehr auftritt. Gängig ist beispielsweise eine Frequenz-segmentierte Methode, bei der eine B₀-Karte nach n off-Resonanzen segmentiert wird. Die Messsignale werden unter Einbeziehung verschiedener off-Resonanzen rekonstruiert, d.h. n Bilder für n off-Resonanzen werden rekonstruiert. Anhand der segmentierten B₀-Karte wird für jeden Pixel ausgewählt, welches der n Bilder den korrekt rekonstruierten Pixel enthält.

Es ist daher eine Aufgabe der vorliegenden Erfindung, ein Verfahren zur einfachen und robusten off-Resonanz-Korrektur insbesondere für spiralförmige k-Raum-Trajektorien zu implementieren.

Diese Aufgabe wird gelöst durch ein Verfahren zur Erzeugung wenigstens eines Bilddatensatzes und eines Referenzbilddatensatzes eines Untersuchungsobjektes aus wenigstens zwei Rohdatensätzen mit den Schritten:
- Bereitstellen eines ersten Rohdatensatzes, wobei der erste Rohdatensatz mit einer Magnetresonanzanlage aufgenommen ist und Messsignale an mehreren Auslesepunkten im k-Raum umfasst, wobei die Auslesepunkte auf einer ersten k-Raum-Trajektorie liegen,
- Bereitstellen eines zweiten Rohdatensatzes, wobei der zweite Rohdatensatz mit derselben Magnetresonanzanlage und an demselben Untersuchungsobjekt aufgenommen ist wie der erste Rohdatensatz und Messsignale an mehreren Auslesepunkten im k-Raum umfasst, wobei die Auslesepunkte auf einer zweiten, von der ersten Trajektorie unterschiedlichen k-Raum-Trajektorie liegen, wobei die erste k-Raum-Trajektorie auf Grundmagnetfeldabweichungen empfindlicher ist als die zweite k-Raumtrajektorie,
- Rekonstruktion mehrerer Bilddatensätze aus dem ersten Rohdatensatz, wobei vor der Rekonstruktion jedes Bilddatensatzes ein eigener Entzerrungskoeffizientensatz verwendet wird, wobei ein Entzerrungskoeffizientensatz eine Phasenverschiebung der Messsignale des ersten Rohdatensatzes im k-Raum definiert,
- Rekonstruktion eines Referenzbilddatensatzes aus dem zweiten Rohdatensatz,
- Vergleich der Bilddatensätze mit dem Referenzbilddatensatz, wobei beim Vergleich jeweils ein Ähnlichkeitswert erzeugt wird, und
- Auswahl des Bilddatensatzes mit dem größten Ähnlichkeitswert.

Der k-Raum ist dabei bekanntermaßen der abgetastete Frequenzraum. Er ist ein mathematischer Datenraum, in dem die Messsignale in Form von k-Raum-Punkten darstellbar sind. Über das Nyquist-Kriterium ist festgelegt, wieviele k-Raum-Punkte abgetastet werden müssen, um eine Rekonstruktion ohne Einfaltungsartefakte zu erhalten. Ein derartiger k-Raum wird auch vollständig genannt. Eine Unterabtastung führt dagegen zu sogenannten Einfaltungsartefakten. Es gibt aber Aufnahmearten wie bspw. parallele Bildgebung, bei der auch aus unterabgetasteten k-Räumen mit speziellen Rekonstruktionsverfahren einfaltungsartefaktfreie Bilddatensätze erhalten werden können.

Zur Abtastung des k-Raums existieren mehrere Möglichkeiten. So können sich auch bei einer kartesischen Abtastung über die Reihenfolge der Aufnahme der k-Raum-Zeilen unterschiedliche Abtastungen ergeben. Der Pfad im k-Raum, der durch die Gradientenfelder nach der oder den HF-Anregungen festgelegt wird, ist die sogenannte k-Raum-Trajektorie. Diese kann in k-Raum-Darstellungen visualisiert werden. Die k-Raum-Trajektorie zeigt also den Pfad der Aufnahme aller Messsignale, die in einen Rohdatensatz eingehen. Eine k-Raum-Trajektorie kann also auch aus Teiltrajektorien bestehen.

Die k-Raum-Punkte, die tatsächlich abgetastet wurden, werden Auslesepunkte genannt. Die Messsignale, die aufgenommen wurden, sind in einem bereits genannten Rohdatensatz abgelegt.

Eine Magnetresonanzanlage mit einer Empfangsspulenanordnung und Gradientenspulen ist dazu ausgebildet, Rohdatensätze mit unterschiedlichen Messsequenzen zu akquirieren. Dadurch können die aus einem Rohdatensatz rekonstruierten Bilddatensätze unterschiedliche Kontraste aufweisen. Auch bei Verwendung derselben Messsequenz können unterschiedliche Abtastschemata verwendet werden, wodurch sich unterschiedliche k-Raum-Trajektorien ergeben.

Es hat sich gezeigt, dass einige k-Raum-Trajektorien auf lokale off-Resonanzen empfindlicher sind als andere, dergestalt, dass sie eher Abweichungen zwischen Ist- und Soll-Phase aufweisen als andere. Daher werden zwei Rohdatensätze bereitgestellt, die mit unterschiedlichen k-Raum-Trajektorien aufgenommen sind. Die gegenüber Grundmagnetfeldabweichungen unempfindlichere k-Raum-Trajektorie wird verwendet, um die empfindlichere k-Raum-Trajektorie zu korrigieren.

Dies geschieht durch gezielte Phasenverschiebungen. Die Verschiebevektoren der einzelnen Auslesepunkte sind in einem Entzerrungskoeffizientensatz zusammengefasst. Mit einem Entzerrungskoeffizientensatz wird der erste Rohdatensatz in einen korrigierten ersten Rohdatensatz umgewandelt und dann durch eine Fouriertransformation zu einem Bilddatensatz rekonstruiert. Zu jedem Entzerrungskoeffizientensatz existiert dann ein eigener Bilddatensatz.

Diese Bilddatensätze, die alle aus dem ersten Rohdatensatz unter Verwendung jeweils eines unterschiedlichen Entzerrungskoeffizientensatzes rekonstruiert worden sind, werden dann mit einem aus dem zweiten Rohdatensatz rekonstruierten Referenzbilddatensatz verglichen. Bei dem Vergleich wird ein Ähnlichkeitswert erzeugt und der Bilddatensatz mit dem größten Ähnlichkeitswert wird weiterverwendet.

Einer der Entzerrungskoeffizientensätze kann auch eine Identitätsabbildung darstellen, also keine Verschiebung vornehmen. Ohne Grundmagnetfeldabweichungen ist der unter Verwendung dieses Entzerrungskoeffizientensatzes rekonstruierte Bilddatensatz derjenige mit dem größten Ähnlichkeitswert.

Der Ähnlichkeitswert wird vorteilhafterweise über einen Kantenvergleich festgelegt. Dann wird bei der Bestimmung der Ähnlichkeit v.a. die Struktur berücksichtigt und nicht Signalintensitätsverteilungen.

Das beschriebene Verfahren kann verschieden oft eingesetzt werden:
Entweder reicht es aus, das Verfahren bei jedem Patienten einmal durchzuführen. Dies ist der Fall, wenn die off-Resonanzen zu immer gleichen Phasenverschiebungen in allen ersten Rohdatensätzen, die von dem Patienten in dieser Sitzung aufgenommen sind, führen. Dann kann der bei einem ersten Rohdatensatz gefundene Entzerrungskoeffizientensatz für alle anderen ersten Rohdatensätze weiterverwendet werden.

Ansonsten ist für jeden ersten Rohdatensatz die beste Entzerrung einzeln zu ermitteln. Es muss also dann auf jeden ersten Rohdatensatz eine Anzahl von Entzerrungskoeffizientensätzen angewendet werden, eine gleiche Anzahl an Bilddatensätzen rekonstruiert werden und der Bilddatensätz mit dem größten Ähnlichkeitswert ermittelt werden.

Vorzugsweise kann als erste k-Raum-Trajektorie eine Trajektorie verwendet werden, bei der die Abtastung zumindest eines Teils des k-Raums unter einem zeitlich variierendem Lesegradienten erfolgt, insbesondere eine Spiraltrajektorie, d.h. eine spiralförmige k-Raum-Trajektorie. Spiraltrajektorien sind auf Grund ihrer relativ langen Auslesedauer wie eingangs beschrieben empfindlich auf Grundmagnetfeldabweichungen, da sich Phasenabweichungen aufsummieren und die Bilddaten in alle Richtungen verschmieren. Dementsprechend weist jeder Auslesepunkt eine unterschiedliche Phasenverschiebung auf. Wie ebenfalls weiter oben beschrieben bezeichnet eine k-Raum-Trajektorie die Gesamtheit aller Messsignale, die zur Rekonstruktion eines Bilddatensatzes verwendet werden. Eine spiralförmige k-Raum-Trajektorie kann daher eine Spirale aufweisen. Sie kann aber auch wenigstens zwei, also mehrere, Spiralen umfassen.

Zur Erzeugung von Spiraltrajektorien werden Messsequenzen verwendet, welche mit zwei oszillierenden Gradienten ausgestattet sind.

Alternativ kann als erste k-Raum-Trajektorie ein Pfad mit wenigstens zwei verbundenen k-Raum-Linien verwendet werden. Eine k-Raum-Linie kann eine k-Raum-Zeile oder eine Speiche sein. Bevorzugt wiesen dabei jeweils zwei aufeinanderfolgende k-Raum-Linien eine unterschiedliche, insbesondere eine entgegengesetzte, Ausleserichtung auf. Eine derartige k-Raum-Trajektorie liegt u.a. bei Multigradientenecho-Messsequenzen wie einer EPI-Messsequenz vor. Auch bei derartigen Messsequenzen summieren sich Grundmagnetfeldabweichungen auf. Bevorzugt weisen die k-Raum-Linien als k-Raum-Zeilen einen Abstand in Phasenkodierrichtung auf, sind also in einer kartesischen Anordnung abgetastet. Alternativ können die k-Raum-Linien auch als Speichen bei einer radialen Abtastung erhalten werden.

Die Verbindung der k-Raum-Linien entsteht also durch das Auslesen eines Multigradientenechos. Dabei werden die Zeilen oder Speichen in einer k-Raum-Darstellung tatsächlich verbunden.

Der k-Raum kann dabei in einem einzigen Zug, als sogenannte "single-shot"-Abtastung, oder segmentiert abgetastet werden. Je mehr k-Raum-Linien in einem Zug aufgenommen werden desto größer ist die Anfälligkeit in Bezug auf Grundmagnetfeldabweichungen.

Des Weiteren sind andere komplizierte Trajektorien denkbar, wie Rosette (https://www.ncbi.nlm.nih.gov/pmc/articles/PMC2746043/) oder grundsätzlich Trajektorien, bei denen auf Grund einer relativ langen Auslesedauer Verzerrungen durch Phasenakkumulation auftreten.

Vorteilhafterweise kann als zweite k-Raum-Trajektorie eine kartesische Verteilung der Auslesepunkte verwendet werden. Diese kann bevorzugt mit einer Messsequenz aufgenommen werden, bei der nur wenige oder bevorzugt ein einziges Gradientenecho aufgenommen wird. Die k-Raum-Trajektorie besteht dann aus einzelnen, unverbundenen k-Raum-Zeilen oder aus Blöcken von wenigen, unverbundenen Zeilen. Wenige Gradientenechos bedeutet weniger Gradientenechos als beim ersten Rohdatensatz, insbesondere maximal 10 Gradientenechos. Vorteilhafterweise wird ein einziges Gradientenecho in einem Zug akquiriert.

Unter das Merkmal der wenigen oder des einzigen Gradientenechos fallen auch alle bildgebenden Spinecho- und Misch-Messsequenzen. Auch bei Spinecho-Messsequenzen wird gleichzeitig zum Spinecho mittels eines Lese-Dephasiergradienten und den folgenden Lesegradienten ein Gradientenecho erzeugt.

Vorzugsweise werden zur Rekonstruktion des Referenzbilddatensatzes nur eines der ersten Gradientenechosignale oder die ersten Gradientenechosignale verwendet. Wird bei der Aufnahme der Rohdaten eine Turbospinecho-Messsequenz zusammen mit einem 2-point-Dixon-Verfahren kombiniert, so dient das jeweils zweite Gradientenecho zur Erzeugung eines zweiten Bilddatensatzes. Derartige Gradientenechos sind aber unerheblich für den Referenzbilddatensatz, der vorteilhafterweise aus den jeweils ersten Gradientenechos rekonstruiert wird.

Alternativ kann als zweite k-Raum-Trajektorie ein Pfad mit unverbundenen Speichen oder wenigen verbundenen Speichen verwendet werden. Auch eine radiale Abtastung mit einem einzigen oder wenigen Gradientenechosignalen ist also möglich. Auch hier sind die wenigen Gradientenechosignale weniger Gradientenechosignale als beim ersten Rohdatensatz, bevorzugt maximal 10 Gadientenechosignale.

Vorzugsweise kann bei der Erzeugung zumindest eines Entzerrungskoeffizientensatzes ein Modell der Grundmagnetfeldabweichung bei der Aufnahme des ersten Rohdatensatzes verwendet werden. In das Modell können alle Ursachen für Abweichungen einfließen, die bekannt sind. Dafür ist es nicht notwendig, die Abweichungen exakt zu kennen, ansonsten könnten sie von vorneherein bei der Rekonstruktion berücksichtigt werden.

Es kann aber einfließen, ob die Gradientenmomente tendenziell zu groß oder zu klein sind, ob die Grundmagnetfeldabweichung aufgrund von zu erwartenden Suszeptibilitätssprüngen stärker ist. Im Bereich der Lunge sind z.B. größere lokale off-Resonanzen zu erwarten als bei einem Gliedmaße. Es können also im Hinblick auf die erkannten Abweichungen speziell angepasste Entzerrungskoeffizientensätze erzeugt werden.

Weiterhin können im Zentrum des k-Raums größere Phasenverschiebungen vorgesehen sein als weiter außen, da die Grundmagnetfeldabweichungen im Verhältnis zu den anliegenden Gradientenstärken im Zentrum größer sind. Das gesamte Vorwissen über die Lage von Lufeinschlüssen, Shimkorrekturen und die Gradienten kann in die Entzerrungskoeffizientensätze gepackt werden, um eine Entzerrung mit möglichst wenigen Entzerrungskoeffizientensätzen zu erreichen.

Alternativ oder zusätzlich kann zumindest ein Entzerrungskoeffizientensatz mit Zufallszahlen erzeugt werden. In einer ersten Ausgestaltung werden die Phasenverschiebungen für jeden Entzerrungskoeffizientensatz alleine mit Zufallszahlen erzeugt. Dies ist ein Art brute force-Ansatz. Dieses Vorgehen kann immer angewendet werden, da es kein Vorwissen voraussetzt.

In einer zweiten Alternative kann die Verwendung der Zufallszahlen mit der Anwendung von Vorwissen, beispielsweise dem Modell der Grundmagnetfeldabweichung bei der Aufnahme des ersten Rohdatensatzes, kombiniert werden. Dabei können Modellfehler abgefangen werden ohne dass sozusagen blind nach Verschiebewerten gegriffen wird. Eine Kombination kann beispielsweise dadurch erhalten werden, dass Grenzwerte für die Zufallszahlen ortsabhängig vorgegeben werden. Wie weiter oben beschrieben können die Grundmagnetfeldabweichungen in bestimmten Bereichen größer sein. Auch summieren sich Abweichungen auf. Dort sind die Grenzwerte für die Zufallszahlen ebenfalls höher. Man kann also jedes Modell mit Zufallszahlen kombinieren, um die Modelle robuster gegen unberücksichtigte Einflüsse zu halten.

Vorteilhafterweise kann eine maximale Phasenverschiebung für die Messsignale vorgegeben werden. Dabei geht es darum, die Phasenverschiebungen in einem physikalisch sinnvollen Bereich zu halten. Zwar werden bereits bei der Verwendung von Zufallszahlen Grenzwerte für die Zahlen als solche vorgegeben. Man kann aber die sich daraus ergebende Phasenverschiebung mit zusätzlichen Bedingungen versehen. Beispielsweise kann vorgegeben werden, dass bei zwei auf der k-Raum-Trajektorie nebeneinanderliegenden Auslesepunkten der zuerst aufgenommene eine kleinere Phasenverschiebung erhält. Auch dabei geht es darum, die Anzahl der verwendeten Entzerrungskoeffizientensätze auf eine geringst mögliche Anzahl zu beschränken.

Bevorzugt können als erster Rohdatensatz mehrere Teildatensätze bereitgestellt werden, wobei die Teildatensätze mit wenigstens einem unterschiedlichen Messparameter bestehend aus der Gruppe Flipwinkel des Anregungsimpulses und/oder Repetitionszeit aufgenommen sind. Eine besonders wertvolle Anwendung des beschriebenen Verfahrens erfolgt beim Magnetic Resonance Fingerprinting, kurz MRF oder MR Fingerprinting. Beim MR Fingerprinting werden direkt nacheinander Bilddatensätze mit unterschiedlichen Messparametern akquiriert, um Signalverlaufskurven zu erzeugen, die von mehreren Gewebe- und Geräteparametern beeinflusst sind, bspw. von der T1-Relaxationszeit und/oder der T2-Relaxationszeit und/oder der HF-Impulsstärke B1 oder dem Grundmagnetfeld B0.

Jede Signalverlaufskurve wird mit den in einem sogenannten Dictionary abgespeicherten Signalverlaufskurven verglichen und so die Gewebe- und Geräteparameter ermittelt. Jede Signalverlaufskurve wird aus einer Vielzahl von MRF-Bilddatensätzen erhalten, und zwar üblicherweise für jedes Bildelement eine Signalverlaufskurve.

Um die Vielzahl an MRF-Bilddatensätzen, und zwar in der Größenordnung von mehreren hundert, in einer überschaubaren Zeit aufnehmen zu können ist es bekannt, Spiraltrajektorien bei der Aufnahme eines MRF-Bilddatensatzes zu verwenden. Dabei kann es vorkommen, dass ein MRF-Bilddatensatz achtundvierzigfach unterabgetastet ist. Um bei der Erzeugung eines ersten Rohdatensatzes die Unterabtastung zu verringern kann aus mehreren Spiralen eine spiralförmige k-Raum-Trajektorie gebildet werden. Dazu müssen die Spiralen zumindest teilweise unterschiedliche Auslesepunkte aufweisen, ansonsten würde lediglich eine Mittelung vorliegen. Beispielsweise können die Spiralen um einen Winkel gegeneinander verdreht sein. Bei vier Spiralen kann jeweils eine 90°-Drehung vorliegen.

Eine Spirale wird also zur Erzeugung eines MRF-Bilddatensatzes verwendet und mehrere, bspw. vier, Spiralen bilden einen ersten Rohdatensatz zur Erzeugung eines Bilddatensatzes. Dadurch können die Spiralen nicht nur für ein MRF-Verfahren verwendet werden sondern gleichzeitig für eine vorherige Entzerrung.

Damit stellt ein MRF-Rohdatensatz, also die auf einer Spirale liegenden Messsignale, der verwendet wird, einen MRF-Bilddatensatz zu rekonstruieren, einen Teildatensatz eines ersten Rohdatensatzes dar.

Bei der Bereitstellung oder Aufnahme der MRF-Bilddatensätze kommt daher als zusätzliche Aufgabe hinzu, eine Korrektur für einen oder mehrere erste Rohdatensätze zu erhalten, der die Messzeit nicht oder zumindest nicht wesentlich verlängert.

Zur Lösung dieses Problems ist daher vorgesehen, bei der Aufnahme der MRF-Bilddatensätze einen Teil mit einer Spiralabtastung und einen Teil mit einer kartesischen Abtastung aufzunehmen. Dabei ist das eingangs beschriebene Verfahren dahingehend zu ergänzen, dass Messparameter während der Messung variiert werden.

Zusätzlich kann auch die Messsequenz variiert werden, wobei beim MR Fingerprinting die Magnetisierung von Messsequenz zu Messsequenz durch direktes Aufeinanderfolgen der Messsequenzen übernommen wird.

Ein derartiger aufgenommener MRF-Datensatz besteht dann aus mehreren ersten Rohdatensätzen und wenigstens einem zweiten Rohdatensatz. Jeder der ersten Rohdatensätze kann aus mehreren Teildatensätzen bestehen. Dann werden aus ihm mehrere MRF-Bilddatensätze erzeugt. Davon zu unterscheiden ist aber das Vorgehen zum Erhalt einer korrigierten k-Raum-Trajektorie. Dabei wird ein ganzer erster Rohdatensatz trotz der unterschiedlichen Messparameter herangezogen. Im ganzen ersten Rohdatensatz werden die Phasen mittels eines Entzerrungskoeffizientensatzes verschoben und daraus - für jeden Entzerrungskoeffizientensatz - ein einziger Bilddatensatz erzeugt. Hat man diejenige k-Raum-Trajektorie gefunden, bei der der Ähnlichkeitswert maximal ist, kann sie verwendet werden, um die mehreren MRF-Bilddatensätze aus der einzigen k-Raum-Spiraltrajektorie zu rekonstruieren.

Es können dabei zwar sowohl die Bilddatensätze aus der k-Raum-Spiraltrajektorie als auch die MRF-Bilddatensätze aus den Spiralen unterabgetastet sein. Die MRF-Bilddatensätze sind aber wesentlich stärker unterabgetastet. Durch die Verwendung der ersten Rohdatensätze statt der einzelnen Spiralen wird erst die Berechnung sinnvoller Ähnlichkeitswerte möglich. Entzerrungskoeffizientensätze können für jede Art von k-Raum-Trajektorie bereitgestellt werden, allerdings besteht bei zu stark unterabgetasteten Rohdatensätzen das Problem, dass die daraus rekonstruierten Bilddatensätze zu starke Einfaltungsartefakte aufweisen. Dann können keine sinnvollen Ähnlichkeitswerte mehr mit einem Referenzbilddatensatz erstellt werden.

Vorzugsweise können mehrere erste Rohdatensätze bereitgestellt werden und für einen ersten Rohdatensatz ein Entzerrungskoeffizientensatz ausgewählt werden, der für alle ersten Rohdatensätze oder für Teildatensätze der ersten Rohdatensätze verwendet wird. Dies ist ebenfalls eine Anwendung beim MRF-Fingerprinting, insbesondere bei Verwendung unterschiedlicher Messsequenzen mit Spiralabtastung. Es wird dann für einen Bilddatensatz derjenige Entzerrungskoeffizientensatz ermittelt, der zum größten Ähnlichkeitswert führt. Dieser kann dann auf andere erste Rohdatensätze angewendet werden, um diese ebenfalls zu korrigieren.

Vorzugsweise kann nach der Rekonstruktion wenigstens zweier Bilddatensätze aus dem ersten Rohdatensatz unter Verwendung zweier unterschiedlicher Entzerrungskoeffizientensätze die sich ergebenden Ähnlichkeitswerte bei der Erzeugung eines dritten Entzerrungskoeffizientensatzes berücksichtigt werden. Mit anderen Worten kann die Erzeugung der Entzerrungskoeffizientensätze und der Bilddatensätze iterativ geschehen. Man bewertet anhand der Bilddatensätze, welche Entzerrungskoeffizientensätze eine Verbesserung herstellen oder welche eine größere Verbesserung bewirken und versucht diese dann weiter zu verbessern. Beispielsweise kann ein erster Entzerrungskoeffizientensatz Phasenverschiebungen im Zentrum des k-Raums vornehmen und ein zweiter Phasenverschiebungen in den Außenbereichen des k-Raums. Je nachdem, welcher der aus dem ersten Rohdatensatz unter Verwendung des ersten und des zweiten Entzerrungskoeffizientensatzes erzeugten Bilddatensätze einen größeren Ähnlichkeitswert aufweist, wird der Entzerrungskoeffizientensatz abgewandelt, der dem Bilddatensatz mit dem grö-ßeren Ähnlichkeitswert zugeordnet ist.

Bevorzugt kann der erste Rohdatensatz mit einer ersten Messsequenz aufgenommen sein und die Messsequenz zur Aufnahme des zweiten Rohdatensatzes so ausgewählt werden, dass aus dem ersten und dem zweiten Rohdatensatz rekonstruierten Bilddatensätze möglichst gleiche Strukturen aufweisen. Die Gradientenabweichungen bewirken in einem aus einem ersten Rohdatensatz rekonstruierten Bilddatensatz eine Veränderung der Konturen bzw. Strukturen. Der Entzerrungskoeffizientensatz soll diese Veränderung rückgängig machen. Ein Vergleich bspw. der Kanten in einem Bilddatensatz und im Referenzbilddatensatz zeigt dann, wie gut die Entzerrung funktioniert hat. Insbesondere können der erste Rohdatensatz und der zweite Rohdatensatz mit derselben Messsequenz, aber unterschiedlichen k-Raum-Trajektorien, aufgenommen sein.

Vorteilhafterweise kann ein Entzerrungskoeffizientensatz zusätzlich eine Verschiebung der Auslesepunkte der Messsignale definieren. Eine derartige Verschiebung kann durch Gradientenabweichungen verursacht werden. Insbesondere Spiraltrajektorien sind in der Realität z.B. durch Gradientenverstärker-Zeitverschiebungen, Wirbelströme und begleitende Gradientenfelder, auch concomitant gradient fields genannt, verzerrt. Wenn die einzelnen Auslesepunkte verschoben sind ist auch immer die k-Raum-Trajektorie verschoben. Der Auslesepunkt ist dann ein weiterer Parameter, der im Entzerrungskoeffizientensatz vorhanden ist. Damit wird die Entzerrung etwas aufwändiger, am Ende aber noch besser.

Auch in Bezug auf die Verschiebung der Auslesepunkte können die beschriebenen Gedanken zur Erzeugung des Entzerrungskoeffizientensatzes zugrunde gelegt werden. So kann bei der Erzeugung zumindest eines Entzerrungskoeffizientensatzes ein Modell der Gradientenabweichung bei der Aufnahme des ersten Rohdatensatzes verwendet werden. Auch können die Verschiebevektoren ortsabhängig und/oder mit Zufallszahlen erzeugt sein.

Z Die ersten und zweiten Rohdatensätze können in einem nicht zur Erfindung gehörenden Verfahren zum Trainieren eines künstlichen, neuronalen Netzwerkes verwendet werden, umfassend die Schritte:
- Empfangen von Eingangs-Trainingsdaten, wobei die Eingangs-Trainingsdaten der erste Rohdatensatz nach einem der vorangehenden Ansprüche ist,
- Empfangen von Ausgangs-Trainingsdaten, wobei die Ausgangs-Trainingsdaten der zweite Rohdatensatz nach einem der vorangehenden Ansprüche ist,
- Trainieren des neuronalen Netzwerkes mit den Eingangs- und Ausgangstrainingsdaten, insbesondere durch Backpropagation,
- Bereitstellen des trainierten neuronalen Netzwerkes.

Beim MRF entstehen mehrere erste Rohdatensätze. Für jeden von diesen kann zum Trainieren des künstlichen, neuronalen Netzwerkes ein optimaler Entzerrungskoeffizientensatz wie weiter oben beschrieben ermittelt werden. Dann können diese Daten auch verwendet werden, ein neuronales Netzwerk zu trainieren. Mit dem trainierten neuronalen Netzwerk ist es möglich, statt des festen Einbaus von Rohdatensätzen mit einer zweiten k-Raum-Trajektorie, insbesondere mit einer kartesischen Abtastung, zur Erzeugung von Referenzbilddatensätzen diese nur zum Trainieren des künstlichen, neuronalen Netzwerkes zu verwenden und dann wieder MRF-Datensätze zu verwenden, bei denen nur k-Raum-Spiraltrajektorien bei der Abtastung des k-Raums verwendet wurden.

Außerdem kann unter Verwendung eines nicht zur Erfindung gehörenden trainierten neuronalen Netzwerkes wie beschrieben, ein Bilddatensatz erzeugt werden, mit den Schritten:
- Bereitstellen eines ersten Rohdatensatzes, wobei der erste Rohdatensatz mit einer Magnetresonanzanlage aufgenommen ist und Messsignale an mehreren Auslesepunkten im k-Raum umfasst, wobei die Auslesepunkte auf einer ersten k-Raum Trajektorie liegen,
- Anwenden des trainierten neuronalen Netzwerkes wie beschrieben auf den ersten Rohdatensatz, wodurch ein korrigierter erster Rohdatensatz erzeugt wird, und
- Rekonstruktion eines Bilddatensatzes aus dem korrigierten ersten Rohdatensatz.

Ist das neuronale Netzwerk trainiert, kann es für die Entzerrung der ersten Rohdatensätze verwendet werden. Im Rahmen von MRF können wie beschrieben aus einem korrigierten oder entzerrten ersten Rohdatensatz mehrere MRF-Bilddatensätze rekonstruiert werden.

Des Weiteren betrifft die vorliegende Erfindung ein Computerprogrammprodukt, welches man in einen Speicher einer programmierbaren Steuereinrichtung bzw. einer Recheneinheit einer Magnetresonanzanlage laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuereinrichtung läuft. Dabei benötigt das Computerprogrammprodukt eventuell Programmmittel, z.B. Bibliotheken und Hilfsfunktionen, um die entsprechenden Ausführungsformen des Verfahrens zu realisieren. Mit anderen Worten soll mit dem auf das Computerprogrammprodukt gerichteten Anspruch insbesondere eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert und gebunden oder der nur interpretiert werden muss, oder um einen ausführbaren Softwarecode handeln, der zur Ausführung nur noch in die entsprechende Recheneinheit bzw. Steuereinrichtung zu laden ist.

Daneben betrifft die Erfindung eine Magnetresonanzanlage mit einer Steuerungseinrichtung. Die Magnetresonanzanlage zeichnet sich dadurch aus, dass die Steuerungseinrichtung zur Durchführung des Verfahrens wie beschrieben ausgebildet ist.

Weitere vorteilhafte Ausgestaltungen der erfindungsgemäßen Magnetresonanzanlage korrespondieren zu entsprechenden Ausgestaltungen des erfindungsgemäßen Verfahrens. Zur Vermeidung unnötiger Wiederholungen wird somit auf die entsprechenden Verfahrensmerkmale und deren Vorteile verwiesen.

Weitere Vorteile, Merkmale und Besonderheiten der vorliegenden Erfindung ergeben sich aus der nachfolgenden Beschreibung vorteilhafter Ausgestaltungen der Erfindung.

Dabei zeigen:
- Fig. 1: eine Magnetresonanzanlage,
- Fig. 2: ein TrueFISP-Sequenzdiagramm,
- Fig. 3: eine spiralförmige k-Raum-Trajektorie,
- Fig. 4: eine kartesische k-Raum-Trajektorie mit unverbundenen k-Raum-Zeilen,
- Fig. 5: eine kartesische k-Raum-Trajektorie mit verbundenen k-Raum-Zeilen,
- Fig. 6: ein MRF-Verfahren mit mehreren Messsequenzen,
- Fig. 7: einen korrigierten ersten Rohdatensatz,
- Fig. 8: eine erste Ausführungsform eines Verfahrens zur Erzeugung eines Bilddatensatzes, und
- Fig. 9: eine zweite Ausführungsform eines Verfahrens zur Erzeugung eines Bilddatensatzes.

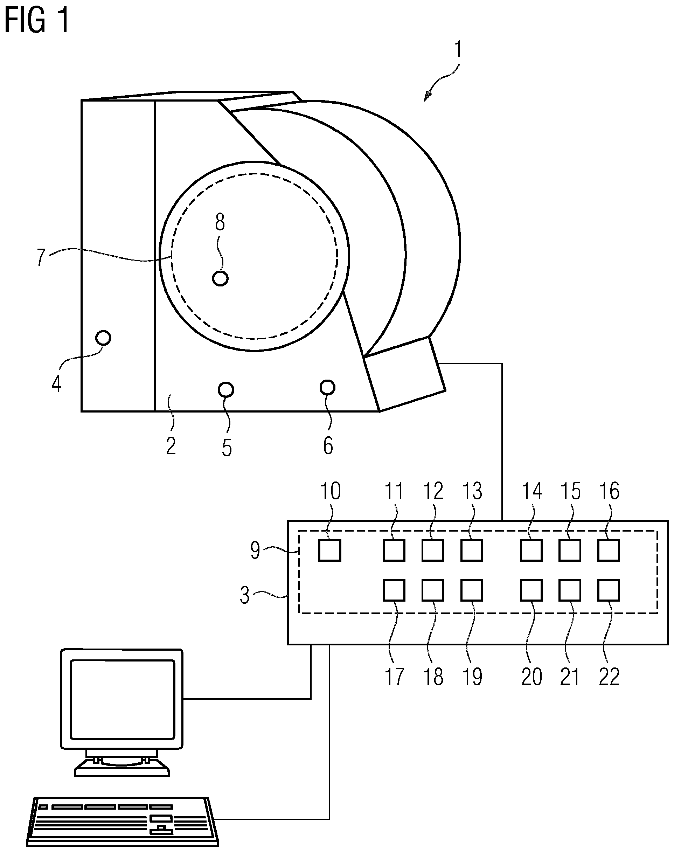

Fig. 1 zeigt eine Magnetresonanzanlage 1 mit einem Scanner 2 und einer Steuerungseinrichtung 3. Der Scanner 2 weist drei Gradientenspulen 4, 5 und 6 zur Erzeugung von Gradientenfeldern auf. Am Scanner 2 ist weiterhin eine Sendespulenanordnung 7 vorhanden. Die Sendespulenanordnung 7 kann als Ganzkörperspule ausgestaltet sein. Es kann sich bei der Sendespulenanordnung 7 aber auch um ein Sendespulenarray handeln.

Die Sendespulenanordnung 7 kann auch zum Signalempfang verwendet werden. Es ist aber zur Steigerung des Signal-Rausch-Verhältnisses SNR auch bekannt, Lokalspulen zu verwenden. Insbesondere kann zur Durchführung von paralleler Bildgebung als Empfangsspulenanordnung 8 ein Spulenarray eingesetzt werden. Mit einem Spulenarray kann die Messzeit verkürzt werden.

Die Steuerungseinrichtung 3 der Magnetresonanzanlage 1 weist einen Datenträger 9 auf, auf dem ein Computerprogrammprodukt 10 zur Durchführung des beschriebenen Verfahrens abgelegt ist. Auch können auf dem Datenträger 9 eine FISP-Messsequenz 11 mit spiraler k-Raum-Abtastung, eine FLASH-Messsequenz 12 mit spiraler k-Raum-Abtastung, eine TrueFISP-Messsequenz 13 mit spiraler k-Raum-Abtastung und eine FISP-Messsequenz 14 mit kartesischer k-Raum-Abtastung unverbundener Zeilen abgelegt sein.

Weiterhin können auch eine EPI-Messsequenz 15 mit kartesischer k-Raum-Abtastung und eine FLASH-Messsequenz 16 mit kartesischer k-Raum-Abtastung abgespeichert sein.

Die FISP-Messsequenz 11 kann zur Aufnahme eines ersten Rohdatensatzes 17 eingesetzt werden. Mit der FLASH-Messsequenz 12 kann ein erster Rohdatensatz 18 akquiriert werden. Die TrueFISP-Messsequenz 13 kann zur Akquisition eines ersten Rohdatensatzes 19 verwendet werden. Ein zweiter Rohdatensatz 20 kann dagegen mit der FISP-Messsequenz 14 erhalten werden.

Ebenso können mit der EPI-Messsequenz 15 ein erster Rohdatensatz 21 und mit der FLASH-Messsequenz 16 ein zweiter Rohdatensatz 22 erhalten werden.

Weitere übliche Bestandteile der Magnetresonanzanlage 1 wie eine Patientenliege, etc. sind der Übersichtlichkeit halber nicht dargestellt.

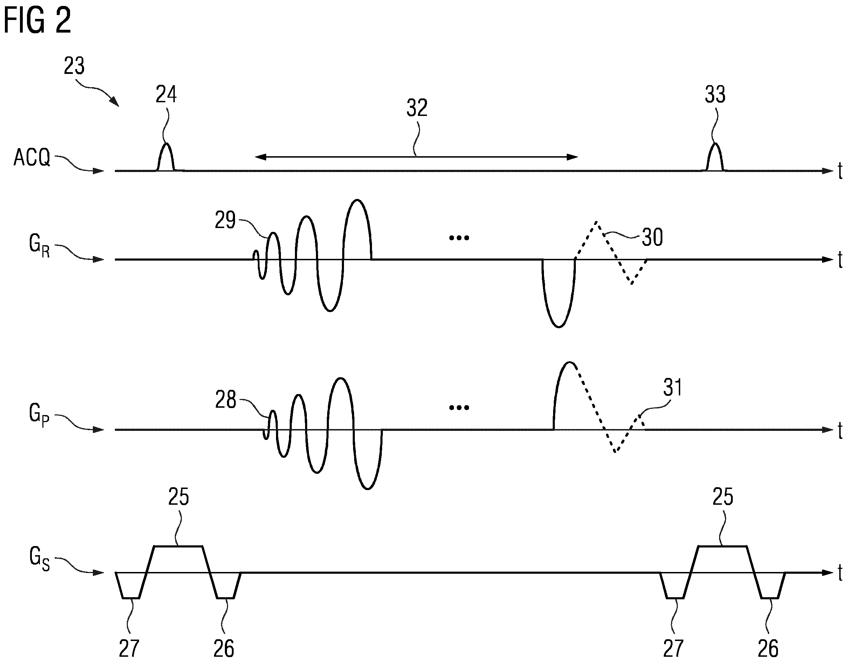

Figur 2 zeigt eine TrueFISP-Sequenzdiagramm 23 zur TrueFISP-Messsequenz 13. Die Gradientenachsen sind wie üblich mit G_{R} für die Leserichtung, G_{P} für die Phasenkodierrichtung und G_{S} für die Schichtauswahlrichtung beschriftet. ACQ bezeichnet die Achse für die Hochfrequenzimpulse und Akquisitionsfenster.

Um mit dem Hochfrequenzimpuls 24 nur eine Schicht anzuregen liegt gleichzeitig zum Hochfrequenzimpuls 24 in Schichtauswahlrichtung G_{S} ein Schichtauswahlgradient 25 an. Um dessen dephasierende Wirkung auf die Magnetisierung in der Transversalebene zu kompensieren folgt direkt auf den Schichtauswahlgradienten 25 ein Schicht-Rephasiergradient 26. Zusätzlich zu diesen Gradienten ist in Schichtauswahlrichtung G_{S} ein Schicht-Dephasiergradient 27 vorhanden. Dieser sorgt dafür, dass die TrueFISP-Messsequenz 13 über eine Repetitionszeit T_{R} "balanced" ist. D.h. es sind über eine Repetitionszeit T_{R} die Summen der Gradientenmomente in Schichtauswahlrichtung GS gleich Null.

In Phasenkodierrichtung G_{P} wird ein Phasenkodiergradient 28 verwendet. Dieser ist, wie der Lesegradient 29 in Leserichtung G_{R}, oszillierend angelegt. Bei nicht-kartesischen Trajektorien spricht man üblicherweise nicht mehr von Gp und GR, sondern von Gx und Gy. Diese Ausgestaltung wird verwendet, um den k-Raum spiralförmig abzutasten.

Zum Ausbalancieren der Gradientenmomente finden sich ein Lese-Rewindgradient 30 und ein Phasen-Rewindgradient 31 am Ende der oszillierend angelegten Gradienten. Diese sind zur besseren Abgrenzung vom Lesegradienten 29 und Phasenkodiergradient 28 gestrichelt dargestellt. Damit ist die TrueFISP-Messsequenz 13 über eine Repetitionszeit T_{R} "fully balanced", d.h. es sind über eine Repetitionszeit T_{R} die Summen der Gradientenmomente in allen Richtungen gleich Null.

In der Akquisitionsphase werden die Messsignale 32 aufgenommen.

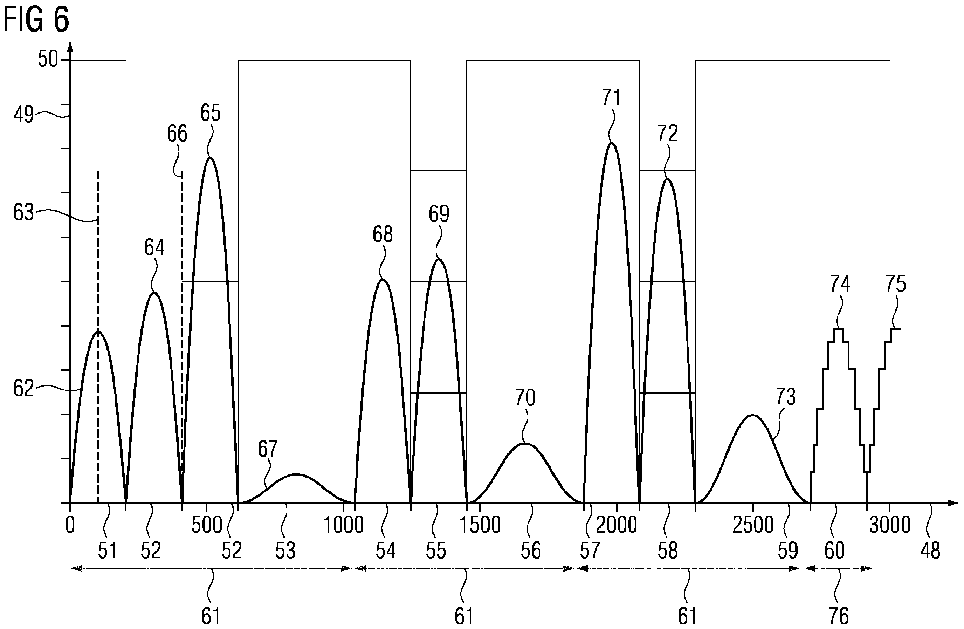

Die Aufnahme eines weiteren Rohdatensatzes wird mit dem Hochfrequenzimpuls 33 begonnen. Dieser besitzt einen anderen Flipwinkel als der vorhergehende Hochfrequenzimpuls 24. Mögliche Variationen der Flipwinkel sind in Fig. 6 dargestellt.

Bei einer FISP-Messsequenz 11 fällt im Vergleich zur TrueFISP-Messsequenz 13 zumindest der Schicht-Dephasiergradient 27 weg, ggf. auch der Lese-Rewindgradient 30. Eine FISP-Messsequenz 11 ist also nur in Phasenrichtung G_{P} ausbalanciert und evtl. in Leserichtung G_{R}, nicht jedoch in der Schichtauswahlrichtung G_{S}.

Eine FLASH-Messsequenz 12 ist im Gegensatz zu einer TrueFISP-Sequenz 13 in keiner Richtung ausbalanciert. Es fehlen dementsprechend der Schicht-Dephasiergradient 27, der Lese-Rewindgradient 30 und der Phase-Rewindgradient 31.

Aufgrund der ansonsten großen Übereinstimmungen wurde daher lediglich ein TrueFISP-Sequenzdiagramm 23 dargestellt, die Abwandlungen für eine FISP-Messsequenz 11 und eine FLASH-Messsequenz 12 ergeben sich wie beschrieben.

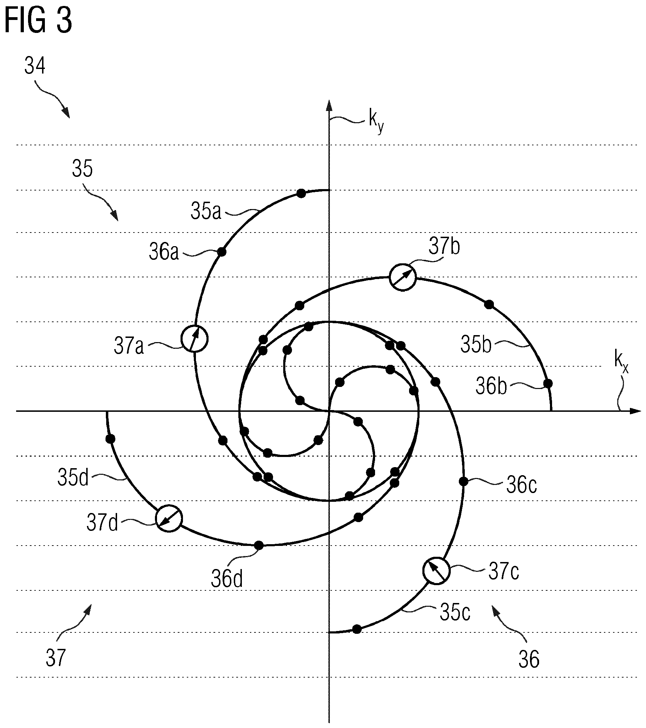

Fig. 3 zeigt einen k-Raum 34 mit einer zu den Messsequenzen 11 bis 13 gehörigen spiralförmigen k-Raum-Trajektorie 35 mit Spiralen 35a, 35b, 35c und 35d. Die vier Spiralen 35a, 35b, 35c und 35d weisen die gleiche Form auf, sind aber in 90°-Schritten gegeneinander verdreht. Dadurch ergibt sich im Zentrum eine dichtere Abtastung des k-Raums 34.

Exemplarisch sind einige Auslesepunkte 36 mit Bezugszeichen versehen, an denen Messsignale 32 aufgenommen werden. Dies ist eine bekannte bildliche Darstellung der Ortskodierung der Messsignale 32.

An vier Auslesepunkten 36 ist exemplarisch eine Phase 37a, 37b, 37c und 37d der Phasenverteilung 37 der k-RaumTrajektorie 35 in der bekannten Uhrzeigerdarstellung eingezeichnet. Eine Phase existiert zu jedem Auslesepunkt, auch wenn nur einige angezeigt wurden. Jeder Auslesepunkt 36 weist eine eigene Phase auf.

Die Verwendung mehrerer Spiralen 35a, 35b, 35c und 35d als spiralförmige k-Raum-Trajektorie 35 ist eine mögliche Ausgestaltung einer Spiraltrajektorie.

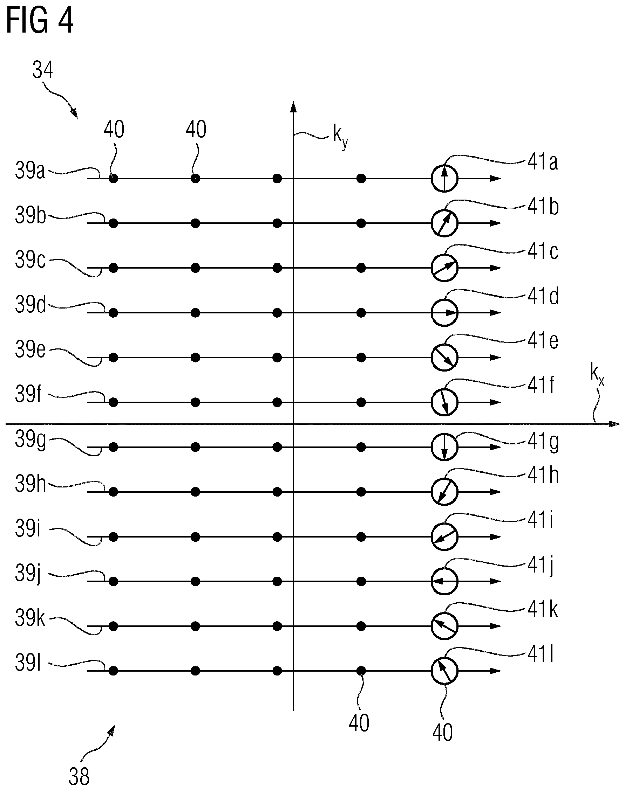

Figur 4 zeigt einen k-Raum 34 mit einer zu den Messsequenzen 14 oder 16 gehörigen k-Raum-Trajektorie 38 mit k-Raum-Zeilen 39a bis 391. Die Auslesepunkte 40 liegen hier auf den k-Raum-Zeilen 39a bis 391. Die k-Raum-Trajektorie 38 besteht aus einzelnen, unverbundenen k-Raum-Zeilen 39a bis 391. Die Pfeilspitzen an den Enden der k-Raum-Zeilen sollen die Gleichheit der Ausleserichtung darstellen, haben ansonsten aber keine Bedeutung.

Die Phasen 41a bis 411 der k-Raum-Zeilen 39a bis 391 sind wieder durch eine Uhrzeigerdarstellung repräsentiert. Die Auslesepunkte 40 einer k-Raum-Zeile haben dabei immer dieselbe Phase.

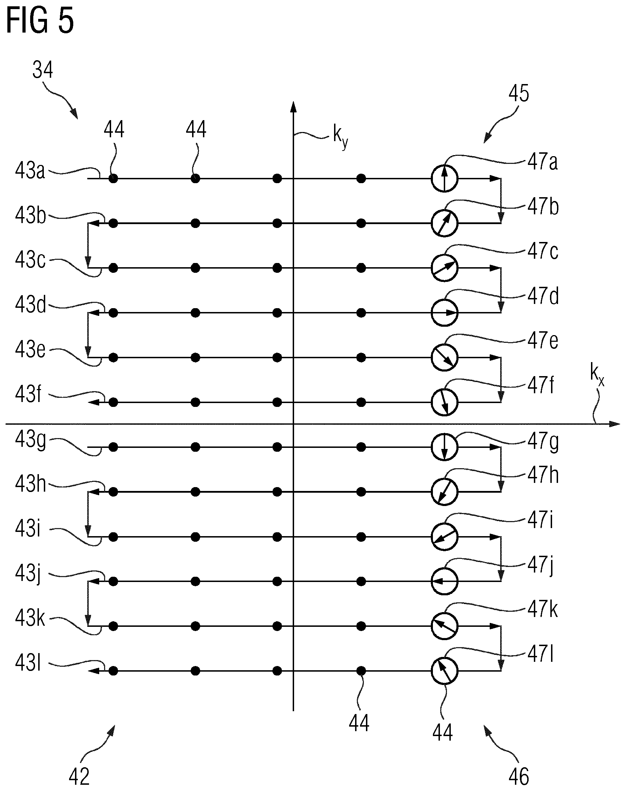

Figur 5 zeigt einen k-Raum 34 mit einer zur EPI-Messsequenz 15 gehörigen k-Raum-Trajektorie 42 mit k-Raum-Zeilen 43a bis 431. Die Auslesepunkte 44 liegen hier auf den k-Raum-Zeilen 43a bis 431. Die k-Raum-Trajektorie 42 besteht aus verbundenen k-Raum-Zeilen 43a bis 43f und 43g bis 431, die in zwei Blöcken 45 und 46 angeordnet sind. Mit anderen Worten ist die Messung segmentiert. Wie weiter oben beschrieben weisen die Blöcke 45 und 46 üblicherweise mehr als zwei k-Raum-Zeilen auf. Der Übersichtlichkeit halber sind nur wenige k-Raum-Zeilen dargestellt.

Auch in Figur 5 werden die Phasen 47a bis 471 der k-Raum-Zeilen 43a bis 431 durch eine Uhrzeigerdarstellung repräsentiert. Die Auslesepunkte 44 einer k-Raum-Zeile haben dabei immer dieselbe Phase.

Wie bereits mehrmals beschrieben umfasst eine k-Raum-Trajektorie, also auch die k-Raum-Trajektorie 42, alle Messsignale 32, hier durch Auslesepunkte 44 repräsentiert, die bei der Erzeugung eines Bilddatensatzes verwendet werden. Sie beinhaltet damit beide Blöcke 45 und 46 und nicht nur einen von beiden.

Figur 6 zeigt schematisch ein Aufnahmeverfahren zur Aufnahme eines MRF-Datensatzes. Dabei sind auf der Achse 48 die Nummer des aufgenommenen MRF-Bilddatensatzes und auf der Achse 49 unterschiedliche Größen aufgetragen. Als erste Größe ist der Flipwinkel in ° von 0° beim Ursprung bis 90° beim Achsenpunkt 50 aufgetragen. Die Achse 48 läuft vom MRF-Bilddatensatz 1 bis zum MRF-Bilddatensatz 3000.

Die 3000 MRF-Bilddatensätze sind auf elf Abschnitte 51, 52, 53, 54, 55, 56, 57, 58, 59 und 60 verteilt.

Im ersten Abschnitt 51 ist über die Kurve 62 für zweihundert MRF-Bilddatensätze der Flipwinkel der FISP-Messsequenz 12 aufgetragen, der bei der Aufnahme verwendet wurde. Wie zu Figur 2 beschrieben wird nach dem Anlegen eines Hochfrequenzimpulses mit einem bestimmten Flipwinkel eine komplette Spirale aufgenommen und dann der nächste Hochfrequenzimpuls mit dem nächsten Flipwinkel angelegt und eine weitere, um 90° gedrehte Spirale abgetastet. Figur 6 zeigt in Abschnitt 51 dementsprechend eine Flipwinkelverteilung, die einer sin²-Kurve entspricht. Der maximale Flipwinkel ist 24° groß und es werden konstante Phasen verwendet.

Für den hundertsten MRF-Bilddatensatz ist rein exemplarisch eine Linie 63 eingetragen. Der korrespondierende Flipwinkel ist der maximale Flipwinkel der Kurve 62.

Im zweiten Abschnitt 52 werden vierhundert MRF-Bilddatensätze mit der TrueFISP-Sequenz 13 gemäß Figur 2 akquiriert. Dabei werden Flipwinkel gemäß der Kurven 64 und 65 eingesetzt. Bei der Kurve 64 reichen diese bis 45° und bei der Kurve 65 bis 72°.

Auch für den Abschnitt 52 ist rein exemplarisch beim vierhundertsten MRF-Bilddatensatz eine Linie 66 eingezeichnet. Hier beträgt der Flipwinkel 1°.

Eine Besonderheit stellt im Abschnitt 52 die Verwendung zweier unterschiedlicher Phasenzyklen dar. Beim Durchlaufen der Flipwinkel der Kurve 64 wird kein Phasenzyklus verwendet und beim Durchlaufen der Kurve 65 ein 180°-Phasenzyklus. Ein Phasenzyklus bezieht sich auf die Anregungsphase des Hochfrequenzimpulses und ist von der Phase der Magnetresonanzsignale verschieden.

Im folgenden Abschnitt 53 sind in der Kurve 67 die Flipwinkel zur Aufnahme von vierhundertfünfzig MRF-Bilddatensätzen mit einer FLASH-Messsequenz 12 angegeben. Diese sind kleiner als in der FISP- oder TrueFISP-Messsequenz und laufen bis 6°. Auch ihre Verteilung ist eine sin²-Verteilung.

Zusätzlich zur Variation der Flipwinkel wird beim wiederholten Durchlaufen der FLASH-Sequenz ein Phasenzyklus zur Realisierung eines RF-Spoiling angelegt. Dabei wird die Anregungsphase des Hochfrequenzimpulses um Vielfache von 117° erhöht.

Die Abfolge der Messsequenzen 11, 12 und 13 bilden zusammen einen Block 61. Dieser wird in Figur 6 insgesamt dreimal verwendet. Dabei wird allein auf den Typ der Messsequenz aber nicht auf die Anzahl der MRF-Bilddatensätze oder die Flipwinkelkurven abgestellt.

Im Abschnitt 54 werden wieder 200 MRF-Bilddatensätze mit einer FISP-Sequenz 11 aufgenommen. Die Phase ist wie in Abschnitt 51 konstant, aber der maximale Flipwinkel beträgt 45°. Diese liegen auf der Kurve 68.

In Abschnitt 55 folgen 200 MRF-Bilddatensätze, die mit einer TrueFISP-Messsequenz 13 zu akquirieren sind. Hier wird ein 90°-Phasenzyklus eingesetzt, der maximale Flipwinkel liegt bei 50°. Die Flipwinkel sind auf der Kurve 69 aufgetragen.

Die nächsten ca. 450 MRF-Bilddatensätze in Abschnitt 56 sind, wie in Abschnitt 53, mit einer FLASH-Messsequenz 12 aufzunehmen. Die Kurve 70 zeigt eine sin²-Verteilung mit einem Maximalwert von 14°.

Die Kurve 71 in Abschnitt 57 läuft bis 72° und zeigt die Flipwinkel des Hochfrequenzimpulses 24 bzw. 33 beim drittmaligen Verwenden einer FISP-Messsequenz 11. Auch in diesem Durchlauf ist die Anregungsphase konstant.

Beim Akquirieren weiterer zweihundert MFR-Bilddatensätze in Abschnitt 58 mit einer TrueFISP-Messsequenz 13 gemäß Figur 2 wird ein 270°-Phasenzyklus eingesetzt. Die Flipwinkel, die in der Kurve 72 aufgetragen sind, laufen bis 65°.

Die nächsten ca. 450 MRF-Bilddatensätze in Abschnitt 59 werden mit der FLASH-Messsequenz 16 aufgenommen. Die Kurve 73 stellt einen Flipwinkelverlauf bis maximal 20° dar, wiederum sin²-verteilt.

Bis zu diesem Abschnitt wurden immer Messsequenzen mit Spiraltrajektorien zur Abtastung des k-Raums verwendet. Die akquirierten Rohdatensätze sind erste Rohdatensätze. Dabei werden die auf Spiralen abgetasteten Messsignale jeweils vier aufeinanderfolgender MRF-Bilddatensätze zu einem ersten Rohdatensatz zusammengefasst. Die Anzahl der ersten Rohdatensätze ist also ein Viertel der Anzahl der MRF-Bilddatensätze.

Im Folgenden wird eine kartesische Abtastung verwendet, wie sie in Figur 4 dargestellt ist.

Im letzten Abschnitt 60 liegen zwei Kurven 74 und 75 zur Aufnahme von zweiten Rohdatensätzen mit einer FISP-Messsequenz 14. Diese stellen wiederum Flipwinkelverläufe dar. Wie bereits in den vorhergehenden Abschnitten wird bei der FISP-Messsequenz 18 eine konstante Anregungsphase des Hochfrequenzimpulses verwendet. Mehrere k-Raum-Zeilen, die zur Erzeugung eines MRF-Bilddatensatzes verwendet werden, können mit demselben Flipwinkel aufgenommen sein. Ein zweiter Rohdatensatz umfasst dann, wie beim ersten Rohdatensatz, ein bestimmtes Vielfaches der mehreren k-Raum-Zeilen. Bspw. können vier k-Raum-Zeilen zur Rekonstruktion eines MRF-Bilddatensatzes verwendet werden und sechszehn, also viermal vier, zur Rekonstruktion eines Refrenzbilddatensatzes. Dementsprechend umfasst die k-Raum-Trajektorie des zweiten Rohdatensatzes sechzehn unverbundene k-Raum-Zeilen.

Der Abschnitt mit den kartesisch abgetasteten zweiten Rohdatensätzen bildet einen Block 76.

Zusammenfassend kann man festhalten, dass, unabhängig von der konkreten Bildanzahl und den jeweils maximalen Flipwinkeln, in allen Abschnitten vorzugsweise ein sin²-verteilter Flipwinkelverlauf verwendet wird. Es können in einem Abschnitt auch erheblich weniger Bilddatensätze aufgenommen werden, bevorzugt aber wenigstens 10.

Die so aufgenommenen ersten und zweiten Rohdatensätze bilden zusammen einen MRF-Datensatz.

Es muss zwar lediglich ein einziger zweiter Rohdatensatz zur Durchführung des Verfahrens vorhanden sein. In diesem Beispiel werden mehrere zweite Rohdatensätze akquiriert, um die Kurven 74 und 75 abzutasten. Dann können die zweiten Rohdatensätze auch zur Erzeugung jeweils mehrerer MRF-Bilddatensätze verwendet werden.

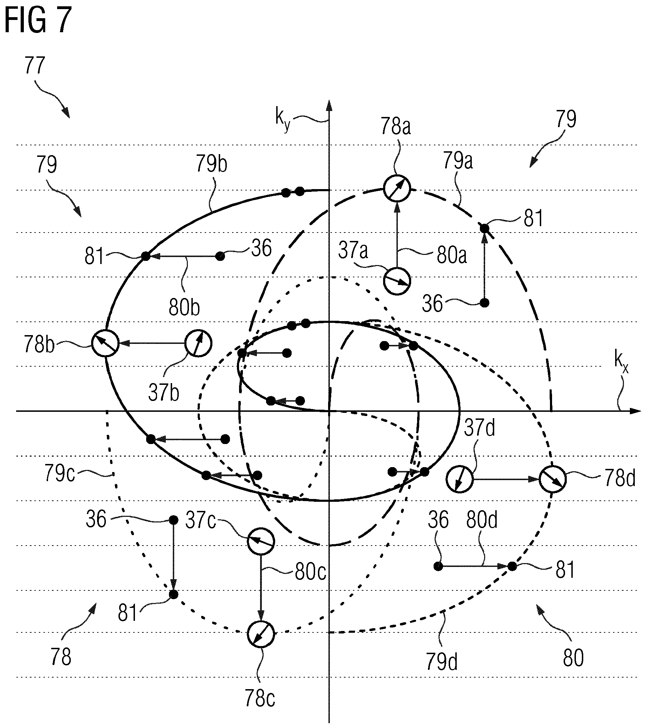

Fig. 7 zeigt einen korrigierten ersten Rohdatensatz 77 mit einer korrigierten Phasenverteilung 78 und einer korrigierten k-Raum-Trajektorie 79. Dabei ist ein Entzerrungskoeffizientensatz 80 auf einen ersten Rohdatensatz angewendet worden. Vom Entzerrungskoeffizientensatz 80 sind exemplarisch die Verschiebevektoren 80a bis 80d mit Bezugszeichen versehen. Dadurch werden die Phasen 37a bis 37d zu korrigierten Phasen 78a bis 78d und die Auslesepunkte 36 zu korrigierten Auslesepunkten 81 verschoben.

Jeder Verschiebevektor 80a bis 80d bewirkt eine Phasenverschiebung der Phasen 37a bis 37c und/oder eine örtliche Verschiebung der Auslesepunkte 36 im k-Raum 34, wobei in Figur 7 beide Verschiebungen dargestellt sind. Er kann aber auch als Identitätsverschiebung ausgebildet sein. Dann ändert er nichts. Sowohl der Auslesepunkt als auch die Phase sind Parameter eines einzigen Messsignals, weswegen die Entzerrung dieser Parameter auch jeweils in einem einzigen Verschiebevektor 80a bis 80d zusammengefasst werden kann.

Die Wirkung eines Entzerrungskoeffizientensatzes 80 ist exemplarisch für vier Spiralen 79a bis 79d einer spiralförmige k-Raum-Trajektorie 79 dargestellt. Bei einer spiralförmigen Abtastung kann also nicht nur eine Spirale verwendet werden, sondern auch mehrere gegeneinander versetzte oder verdrehte Spiralen. Selbstverständlich können entsprechende Verschiebevektoren und Entzerrungskoeffizientensätze 80 für beliebige k-Raum-Trajektorien verwendet werden.

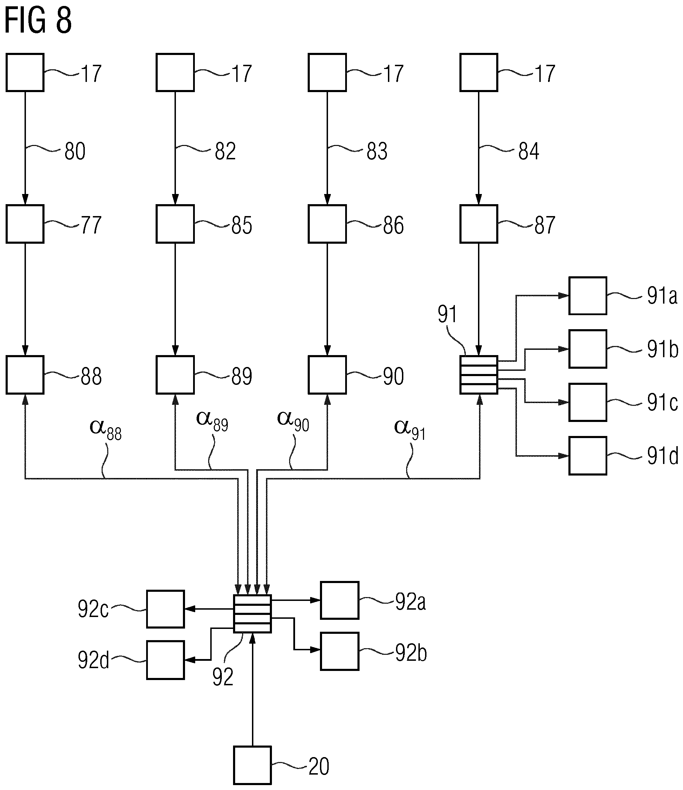

Fig. 8 zeigt eine erste Ausführungsform zur Rekonstruktion von Bilddatensätzen. Dabei werden ausgehend von einem ersten Rohdatensatz 17 durch Anwendung von Entzerrungskoeffizientensätzen 80, 82, 83 und 84 korrigierte erste Rohdatensätze 77, 85, 86 und 87 erzeugt. Aus jedem korrigierten ersten Rohdatensatz 77, 85, 86 und 87 wird ein Bilddatensatz 88, 89, 90 und 91 erzeugt.

Aus dem zweiten Rohdatensatz 20 wird ohne Änderungen ein Referenzbilddatensatz 92 erzeugt.

Die Bilddatensätze 88, 89, 90 und 91 werden mit dem Referenzbilddatensatz 92 verglichen und jeweils ein Ähnlichkeitswert α₈₈, α₈₉, α₉₀ und α₉₁ ermittelt. Derjenige Bilddatensatz mit dem größten Ähnlichkeitswert wird ausgewählt.

Ist dies bspw. der Bilddatensatz 91, und ist dieser Teil eines MRF-Datensatzes, so werden aus einzelnen Spiralen 79a bis 79d der k-Raum-Trajektorie 79 des Bilddatensatzes 91 MRF-Bilddatensätze 91a, 91b, 91c und 91d erzeugt.

Im Zusammenhang mit MR Fingerprinting kann der Referenzbilddatensatz 92 ebenfalls mit variierenden Messparametern bei der Akquisition der k-Raum-Zeilen aufgenommen sein. Dann können auch aus dem Referenzbilddatensatz 92 MRF-Bilddatensätze 92a, 92b, 92c und 92d erzeugt werden. Zu jedem der Bildelemente wird aus den MRF-Bilddatensätzen 91a, 91b, 91c, 91d, 92a, 92b, 92c und 92d eine Signalverlaufskurve erstellt und mit einem Dictionary abgeglichen. So werden für jedes Bildelement Werte für bspw. T1, T2, B0 und B1 erhalten.

Dabei sind die MRF-Bilddatensätzen 91a, 91b, 91c und 91d vierfach unterabgetastet im Vergleich zum Bilddatensatz 91 und die MRF-Bilddatensätzen 92a, 92b, 92c und 92d vierfach unterabgetastet im Vergleich zum Referenzbilddatensatz 92. Dies ist aber möglich, da die MRF-Bilddatensätzen 91a, 91b, 91c, 91d, 92a, 92b, 92c und 92d wie beschrieben zur Erstellung von Signalverlaufskurven verwendet werden und nicht zur direkten Betrachtung.

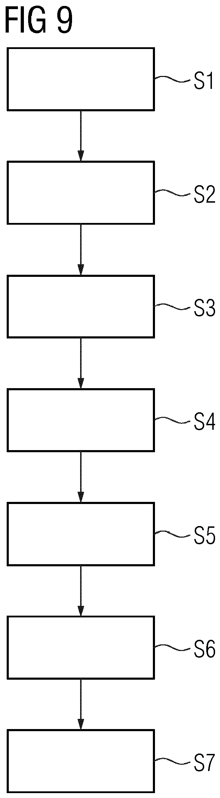

Fig. 9 zeigt ein Ablaufschema einer zweiten Ausführungsform zur Erzeugung eines Bilddatensatzes.

In Schritt S1 werden ein erster Rohdatensatz 17 und ein zweiter Rohdatensatz 20 bereitgestellt. Der erste Rohdatensatz 17 ist mit einer Spiralabtastung aufgenommen und der zweite Rohdatensatz 20 mit einer kartesischen Abtastung.

In Schritt S2 wird die k-Raum-Trajektorie des ersten Rohdatensatzes 17 unter Verwendung eines ersten Entzerrungskoeffizientensatzes 80 verschoben und aus der korrigierten k-Raum-Trajektorie 79 mittels Regridding ein kartesischer Zwischendatensatz generiert. Dieser Zwischendatensatz wird mittels Fouriertransformation zu einem ersten Bilddatensatzes 88 rekonstruiert.

Das Regridding und die Fouriertransformation sind bei der Rekonstruktion von Rohdatensätzen mit Spiraltrajektorien übliche Rekonstruktionsschritte.

Danach wird in Schritt S3 aus demselben ersten Rohdatensatz 17 ein zweiter Bilddatensatz 89 unter Verwendung eines zweiten Entzerrungskoeffizientensatzes 82 rekonstruiert.

Im folgenden Schritt S4 wird aus dem zweiten Rohdatensatz 20 ein Referenzbilddatensatz 91 rekonstruierAnmt. Danach werden in Schritt S5 Ähnlichkeitswerte α₈₈ und α₈₉ ermittelt. Der zu dem Bilddatensatz mit dem größeren Ähnlichkeitswert gehörige Entzerrungskoeffizientensatz wird als Ausgangsbasis bei der Ermittlung eines dritten Entzerrungskoeffizientensatzes 83 verwendet. Sei der erste Entzerrungskoeffizientensatz 80 derjenige, dessen Bilddatensatz den größeren Ähnlichkeitswert aufwies. Bspw. können dann die Verschiebungsvektoren des ersten Entzerrungskoeffizientensatzes 80 einen positiven "Eintrag" bekommen und die des zweiten Entzerrungskoeffizientensatzes 82 einen negativen.

In Schritt S6 wird aus dem oben erwähnten ersten Rohdatensatz 17 ein dritter Bilddatensatz 90 unter Verwendung des dritten Entzerrungskoeffizientensatzes 83 rekonstruiert und einen Ähnlichkeitswert α₉₀ zum Referenzbilddatensatz 92 bestimmt. Je nachdem, ob der Ähnlichkeitswert α₉₀ größer oder kleiner als der bisherige beste Ähnlichkeitswert ist wird der dritte Entzerrungskoeffizientensatz 83 weiterverwendet oder der erste Entzerrungskoeffizientensatz 80.

Selbstevsrtändlich können zu Beginn mehr als zwei Entzerrungskoeffizientensätze verwendet werden, um eine Ausgangsbasis festzulegen. Insbesondere können die anfänglichen Entzerrungskoeefizientensätze vorgegebene Vorgaben erfüllen, z.B. nur im Zentrum oder nur im Außenbereich verschieben.

Ausgehend von dieser iterativen Anpassung der Entzerrungskoeffizientensätze kann das Verfahren solange fortgeführt werden, bis ein Abbruchkriterium erfüllt ist. Dies kann ein maximaler Iterationsschritt oder das Erreichen eines vorgegebenen Ähnlichkeitswertes sein.

Das Verfahren kann bei Vorliegen nur eines ersten Rohdatensatzes dann abschließen.

Sind aber, wie zu Figur 6 gezeigt, eine Vielzahl an ersten Rohdatensätzen vorhanden, kann in Schritt S7 der Entzerrungskoeffizientensatz gespeichert werden, der zu dem Bilddatensatz mit dem größten Ähnlichkeitswert gehört. Dieser wird verwendet, um auch die anderen ersten Rohdatensätze zu entzerren und daraus MRF-Bilddatensätze zu rekonstruieren.

Als erster Rohdatensatz 17 wird dabei auf einen Rohdatensatz zurückgegriffen, der mit derselben Messsequenz aufgenommen wurde wie der zweite Rohdatensatz. Im Beispiel zu Fig. 6 war dies die FISP-Messsequenz.

## Patentansprüche

1. Verfahren zur Erzeugung wenigstens eines Bilddatensatzes (90) und eines Referenzbilddatensatzes (91) eines Untersuchungsobjektes aus wenigstens zwei Rohdatensätzen (17, 20) mit den Schritten:
- Bereitstellen eines ersten Rohdatensatzes (17), wobei der erste Rohdatensatz (17) mit einer Magnetresonanzanlage (1) aufgenommen ist und Messsignale (32) an mehreren Auslesepunkten (36, 44) im k-Raum (34) umfasst, wobei die Auslesepunkte (36, 44) auf einer ersten k-Raum-Trajektorie (35, 42) liegen,
- Bereitstellen eines zweiten Rohdatensatzes (20), wobei der zweite Rohdatensatz (20) mit derselben Magnetresonanzanlage (1) und an demselben Untersuchungsobjekt aufgenommen ist wie der erste Rohdatensatz (17) und Messsignale (32) an mehreren Auslesepunkten (40) im k-Raum (34) umfasst, wobei die Auslesepunkte (40) auf einer zweiten, von der ersten k-Raum-Trajektorie (35, 42) unterschiedlichen k-Raum-Trajektorie (38) liegen, wobei die erste k-Raum-Trajektorie auf Grundmagnetfeldabweichungen empfindlicher ist als die zweite k-Raumtrajektorie,
- Rekonstruktion mehrerer Bilddatensätze (88, 89, 90, 91) aus dem ersten Rohdatensatz (17), wobei vor der Rekonstruktion jedes Bilddatensatzes (88, 89, 90, 91) ein eigener Entzerrungskoeffizientensatz (80, 82, 83, 84) verwendet wird, wobei ein Entzerrungskoeffizientensatz (80, 82, 83, 84) eine Phasenverschiebung (78) der Phasen (37a, 37b, 37c, 37d) der Messsignale (32) des ersten Rohdatensatzes (17) im k-Raum (34) definiert,
- Rekonstruktion eines Referenzbilddatensatzes (92) aus dem zweiten Rohdatensatz (20),
- Vergleich der Bilddatensätze (88, 89, 90, 91) mit dem Referenzbilddatensatz (92), wobei beim Vergleich jeweils ein Ähnlichkeitswert (α₈₈, α₈₉, α₉₀, α₉₁) erzeugt wird, und
- Auswahl des Bilddatensatzes (88, 89, 90, 91) mit dem größten Ähnlichkeitswert (α₈₈, α₈₉, α₉₀, α₉₁).

2. Verfahren nach Anspruch 1, **dadurch gekennzeichnet, dass** als erste k-Raum-Trajektorie (35) eine Trajektorie verwendet wird, bei der die Abtastung zumindest eines Teils des k-Raums unter einem zeitlich variierenden Lesegradienten erfolgt, insbesondere eine Spiraltrajektorie

3. Verfahren nach Anspruch 1 oder 2, **dadurch gekennzeichnet, dass** als zweite k-Raum-Trajektorie (42) eine kartesische Verteilung der Auslesepunkte (44) verwendet wird.

4. Verfahren nach einem der vorangehenden Ansprüche, **dadurch gekennzeichnet, dass** bei der Erzeugung zumindest eines Entzerrungskoeffizientensatzes (80, 82, 83, 84) ein Modell der Magnetfeldabweichung bei der Aufnahme des ersten Rohdatensatzes (17) verwendet wird.

5. Verfahren nach einem der vorangehenden Ansprüche, **dadurch gekennzeichnet, dass** zumindest ein Entzerrungskoeffizientensatz (80, 82, 83, 84) mit Zufallszahlen erzeugt wird.

6. Verfahren nach einem der vorangehenden Ansprüche, **dadurch gekennzeichnet, dass** eine maximale Phasenverschiebung für die Messsignale (32) vorgegeben wird.

7. Verfahren nach einem der vorangehenden Ansprüche, **dadurch gekennzeichnet, dass** als erster Rohdatensatz (17) mehrere Teildatensätze (35a, 35b, 35c, 35d) bereitgestellt werden, wobei die Teildatensätze (35a, 35b, 35c, 35d) mit wenigstens einem unterschiedlichen Messparameter bestehend aus der Gruppe Flipwinkel des Anregungsimpulses und/oder Repetitionszeit aufgenommen sind.

8. Verfahren nach einem der vorangehenden Ansprüche, **dadurch gekennzeichnet, dass** mehrere erste Rohdatensätze (17, 18, 19) bereitgestellt werden und für einen ersten Rohdatensatz (17) ein Entzerrungskoeffizientensatz (80, 82, 83, 84) ausgewählt wird, der für alle ersten Rohdatensätze (17, 18, 19) oder für Teildatensätze (35a, 35b, 35c, 35d) der ersten Rohdatensätze (17, 18, 19) verwendet wird.

9. Verfahren nach einem der vorangehenden Ansprüche, **dadurch gekennzeichnet, dass** nach der Rekontruktion wenigstens zweier Bilddatensätze (88, 89) aus dem ersten Rohdatensatz (17) unter Verwendung zweier unterschiedlicher Entzerrungskoeffizientensätze (80, 82) die sich ergebenden Ähnlichkeitswerte (α₈₈, α₈₉) bei der Erzeugung eines dritten Entzerrungskoeffizientensatzes (90) berücksichtigt werden.

10. Verfahren nach einem der vorangehenden Ansprüche, **dadurch gekennzeichnet, dass** der erste Rohdatensatz (17) mit einer ersten Messsequenz (11) aufgenommen ist und die Messsequenz (14) zur Aufnahme des zweiten Rohdatensatzes (20) so ausgewählt wird, dass aus den Rohdatensätzen (17, 20) rekonstruierten Bilddatensätze (88, 89, 90, 91, 92) möglichst gleiche Kontraste aufweisen.

11. Verfahren nach einem der vorangehenden Ansprüche, **dadurch gekennzeichnet, dass** ein Entzerrungskoeffizientensatz (79, 81, 82, 83) zusätzlich eine Verschiebung der Auslesepunkte (36) der Messsignale (32) definiert.

12. Computerprogrammprodukt (10) für eine Steuerungseinrichtung (3) zur Steuerung eines Rechners, insbesondere einer Bilderzeugungseinheit einer Magnetresonanzanlage (1), umfassend Befehle, die bei der Ausführung des Programms durch einen Computer diesen veranlassen, ein Verfahren gemäß einem der vorhergehenden Ansprüche auszuführen.

13. Magnetresonanzanlage (1) mit einer Steuerungseinrichtung (3), **dadurch gekennzeichnet, dass** die Steuerungseinrichtung (3) Mittel, insbesondere ein Computerprogramm gemäß Anspruch 12, zur Durchführung eines Verfahrens nach einem der Ansprüche 1 bis 11 umfasst.

## Claims

1. Method for generating at least one image dataset (90) and one reference image dataset (91) of an examination object from at least two raw datasets (17, 20) comprising the steps:
- Providing a first raw dataset (17), wherein the first raw dataset (17) is recorded using a magnetic resonance system (1) and comprises measurement signals (32) at a plurality of readout points (36, 44) in the k-space (34), wherein the readout points (36, 44) lie on a first k-space trajectory (35, 42),
- Providing a second raw dataset (20), wherein the second raw dataset (20) is recorded using the same magnetic resonance system (1) and on the same examination object as the first raw dataset (17) and comprises measurement signals (32) at a plurality of readout points (40) in the k-space (34), wherein the readout points (40) lie on a second k-space trajectory (38) different from the first k-space trajectory (35, 42), wherein the first k-space trajectory is more sensitive to basic magnetic field deviations than the second k-space trajectory,
- Reconstructing a plurality of image datasets (88, 89, 90, 91) from the first raw dataset (17), wherein a separate equalisation coefficient set (80, 82, 83, 84) is used before the reconstruction of each image dataset (88, 89, 90, 91), wherein an equalisation coefficient set (80, 82, 83, 84) defines a phase shift (78) of the phases (37a, 37b, 37c, 37d) of the measurement signals (32) of the first raw dataset (17) in the k-space (34),
- Reconstructing a reference image dataset (92) from the second raw dataset (20),
- Comparing the image datasets (88, 89, 90, 91) with the reference image dataset (92), wherein a similarity value (α₈₈, α₈₉, α₉₀, α₉₁) is generated in each case during the comparison, and
- Selecting the image dataset (88, 89, 90, 91) with the greatest similarity value (α₈₈, α₈₉, α₉₀, α₉₁).

2. Method according to claim 1, **characterised in that** a trajectory is used as the first k-space trajectory (35), in which the scanning of at least part of the k-space takes place with a reading gradient which varies over time, in particular a spiral trajectory.

3. Method according to claim 1 or 2, **characterised in that** a Cartesian distribution of the readout points (44) is used as a second k-space trajectory (42).

4. Method according to one of the preceding claims,
**characterised in that** a model of the magnetic field deviation during the recording of the first raw dataset (17) is used in the generation of at least one equalisation coefficient set (80, 82, 83, 84).

5. Method according to one of the preceding claims,
**characterised in that** at least one equalisation coefficient set (80, 82, 83, 84) is generated with random numbers.

6. Method according to one of the preceding claims,
**characterised in that** a maximum phase shift is specified for the measurement signals (32).

7. Method according to one of the preceding claims,
**characterised in that** a plurality of partial datasets (35a, 35b, 35c, 35d) is provided as the first raw dataset (17), wherein the partial datasets (35a, 35b, 35c, 35d) are recorded with at least one different measurement parameter consisting of the group of flip angle of the excitation pulse and/or repetition time.

8. Method according to one of the preceding claims,
**characterised in that** a plurality of first raw datasets (17, 18, 19) are provided and an equalisation coefficient set (80, 82, 83, 84) is selected for a first raw dataset (17) which is used for all first raw datasets (17, 18, 19) or for partial datasets (35a, 35b, 35c, 35d) of the first raw datasets (17, 18, 19).

9. Method according to one of the preceding claims,
**characterised in that** after the reconstruction of at least two image datasets (88, 89) from the first raw dataset (17) using two different equalisation coefficient sets (80, 82), the resulting similarity values (α₈₈, α₈₉) are taken into account in the generation of a third equalisation coefficient set (90).

10. Method according to one of the preceding claims,
**characterised in that** the first raw dataset (17) is recorded using a first measurement sequence (11) and the measurement sequence (14) for recording the second raw dataset (20) is selected in such a way that image datasets (88, 89, 90, 91, 92) reconstructed from the raw datasets (17, 20) have contrasts which are as similar as possible.

11. Method according to one of the preceding claims,
**characterised in that** an equalisation coefficient set (79, 81, 82, 83) additionally defines a shift of the readout points (36) of the measurement signals (32).

12. Computer program product (10) for a control facility (3) for controlling a computer, in particular an image generation unit of a magnetic resonance system (1), comprising commands, which, when the program is executed by a computer, trigger this to carry out a method according to one of the preceding claims.

13. Magnetic resonance system (1) with a control facility (3), **characterised in that** the control facility (3) comprises means, in particular a computer program according to claim 12, to carry out a method according to one of claims 1 to 11.

## Revendications

1. Procédé de production d'au moins un ensemble (90) de données d'image et d'un ensemble (91) de données d'image de référence d'un objet à examiner, à partir d'au moins deux ensembles (17, 20) de données brut, comprenant les stades :
- on se procure un premier ensemble (17) de données brut, dans lequel le premier ensemble (17) de données brut est enregistré par une installation (1) de résonnance magnétique et comprend des signaux (32) de mesure en plusieurs points (36, 44) de lecture dans l'espace k (34), dans lequel les points (36, 44) de lecture sont sur une première trajectoire (35, 42) dans l'espace k,
- on se procure un deuxième ensemble (20) de données brut, dans lequel le deuxième ensemble (20) de données brut est enregistré sur la même installation (1) de résonnance magnétique et sur le même objet à examiner que le premier ensemble (17) de données brut et comprend des signaux (32) de mesure en plusieurs points (40) de lecture dans l'espace k (34), dans lequel les points (40) de lecture sont sur une deuxième trajectoire (38) de l'espace k différente de la première trajectoire (35, 42) dans l'espace k, dans lequel la première trajectoire dans l'espace k est plus sensible à des écarts du champ magnétique de base que la deuxième trajectoire dans l'espace k,
- on reconstruit plusieurs ensembles (88, 89, 90, 91) de données d'image, à partir du premier ensemble (17) de données brut, dans lequel, avant la reconstruction de chaque ensemble (88, 89, 90, 91) de données d'image, on utilise un ensemble (80, 82, 83, 84) propre de coefficients de correction, dans lequel un ensemble (80, 82, 83, 84) de coefficients de correction définit un déphasage (78) des phases (37a, 37b, 37c, 37d) des signaux (32) de mesure du premier ensemble (17) de données brut dans l'espace k (34),
- on reconstruit un ensemble (92) de données d'image de référence à partir du deuxième ensemble (20) de données brut,
- on compare les ensembles (88, 89, 90, 91) de données d'image à l'ensemble (92) de données d'image de référence, dans lequel, lors de la comparaison, on produit respectivement une valeur (α₈₈, α₈₉, α₉₀, α₉₁) de similitude, et
- on choisit l'ensemble (88, 89, 90, 91) de données d'image ayant la valeur (α₈₈, α₈₉, α₉₀, α₉₁) de similitude la plus grande,

2. Procédé suivant la revendication 1, **caractérisé en ce que** l'on utilise, comme première trajectoire (35) dans l'espace k, une trajectoire pour laquelle le balayage d'au moins une partie de l'espace k s'effectue sous un gradient de lecture variable dans le temps, en utilisant en particulier une trajectoire en spirale.

3. Procédé suivant la revendication 1 ou 2, **caractérisé en ce que** l'on utilise, comme deuxième trajectoire (42) dans l'espace k, une répartition cartésienne des points (44) de lecture.

4. Procédé suivant l'une des revendications précédentes, **caractérisé en ce que**, lors de la production d'au moins un ensemble (80, 82, 83, 84) de coefficients de correction, on utilise un modèle de l'écart de champ magnétique lors de l'enregistrement du premier ensemble (17) de données brut.

5. Procédé suivant l'une des revendications précédentes, **caractérisé en ce que** l'on produit au moins un ensemble (80, 82, 83, 84) de coefficients de correction par des nombres aléatoires.

6. Procédé suivant l'une des revendications précédentes, **caractérisé en ce que** l'on prescrit un déphasage maximum des signaux (32) de mesure.

7. Procédé suivant l'une des revendications précédentes, **caractérisé en ce que** l'on se procure, comme premier ensemble (17) de données brut, plusieurs ensembles (35a, 35b, 35c, 35d) de données partiels, dans lequel on enregistre les ensembles (35a, 35b, 35c, 35d) de données partiels avec au moins un paramètre de mesure différent constitué de l'angle de flip de groupe de l'impulsion d'excitation et/ou du temps de répétition.

8. Procédé suivant l'une des revendications précédentes, **caractérisé en ce que** l'on se procure plusieurs premiers ensembles (17, 18, 19) de données partiels et on choisit, pour un premier ensemble (17) de données partiels, un ensemble (80, 82, 83, 84) de coefficients de correction, que l'on utilise pour tous les premiers ensembles (17, 18, 19) de données brut ou pour des ensembles (35a, 35b, 35c, 35d) de données partiels des premiers ensembles (17, 18, 19) de données brut.

9. Procédé suivant l'une des revendications précédentes, **caractérisé en ce que**, après la reconstruction d'au moins deux ensembles (88, 89) de données d'image, à partir du premier ensemble (17) de données brut, en utilisant deux ensembles (80, 82) de coefficients de correction différents, on prend en compte les valeurs (α₈₈, α₈₉) de similitude, qui s'ensuivent, lors de la production d'un troisième ensemble (90) de coefficients de correction.

10. Procédé suivant l'une des revendications précédentes, **caractérisé en ce que** le premier ensemble (17) de données brut est enregistré à une première séquence (11) de mesure, et on choisit la séquence (14) de mesure pour l'enregistrement du deuxième ensemble (20) de données brut, de manière à ce que des ensembles (88, 89, 90, 91, 92) de données d'image, reconstruits à partir des ensembles (17, 20) de données brut, aient autant que possible le même contraste.

11. Procédé suivant l'une des revendications précédentes, **caractérisé en ce qu'**un ensemble (79, 81, 82, 83) de coefficients de correction définit en outre un déplacement des points (36) de lecture des signaux (32) de mesure.

12. Produit (10) de programme d'ordinateur pour un dispositif (3) de commande d'un ordinateur, en particulier d'une unité de production d'image d'une installation (1) de résonnance magnétique, comprenant des instructions qui, lors de la réalisation du programme par ordinateur, font que celles-ci exécutent un procédé suivant l'une des revendications précédentes.

13. Installation (1) de résonnance magnétique comprenant un dispositif (3) de commande, **caractérisée en ce que** le dispositif (3) de commande comprend des moyens, en particulier un programme d'ordinateur suivant la revendication 12, pour effectuer un procédé suivant l'une des revendications 1 à 11.
